# EUROPEAN PATENT SPECIFICATION

(11) **EP 2 416 380 B1**
(45) Date of publication and mention of the grant of the patent: **22.01.2014**
(21) Application number: 10761336.6
(22) Date of filing: 19.03.2010
(51) Int. Cl.: B32B 3/30, H01L 31/048, B32B 27/28, B32B 7/12, B32B 27/08, B32B 27/36, C08J 7/04

(54) **PROTECTIVE SHEET FOR SOLAR BATTERY MODULE, SOLAR BATTERY MODULE AND METHOD FOR PRODUCING SOLAR BATTERY MODULE**
SCHUTZHÜLLE FÜR EIN SOLARZELLENMODUL, SOLARZELLENMODUL UND VERFAHREN ZUR HERSTELLUNG EINES SOLARZELLENMODULS
FEUILLE PROTECTRICE POUR MODULE DE CELLULES SOLAIRES, MODULE DE CELLULES SOLAIRES ET PROCÉDÉ DE FABRICATION D'UN MODULE DE CELLULES SOLAIRES

(30) Priority: 30.03.2009 JP 2009082018
(43) Date of publication of application: 08.02.2012
(73) Proprietor: LINTEC Corporation, Tokyo 173-0001 (JP)
(72) Inventor: TAKANASHI, Yasunari, Tokyo 173-0001 (JP); NOMURA, Shuichi, Tokyo 173-0001 (JP)
(74) Representative: Jansen, Cornelis Marinus
(86) International application number: PCT/JP2010/001982
(87) International publication number: WO 2010/116628

(56) References cited:
- EP-A1- 1 184 912
- WO-A1-01/61763
- JP-A- 2006 198 922
- JP-A- 2007 245 555
- DATABASE WPI Week 200659 Thomson Scientific, London, GB; AN 2006-572007 XP002682234, -& JP 2006 198922 A (MITSUI CHEM INC) 3 August 2006 (2006-08-03)
- DATABASE WPI Week 200782 Thomson Scientific, London, GB; AN 2007-888525 XP002682235, -& JP 2007 245555 A (DAINIPPON PRINTING CO LTD) 27 September 2007 (2007-09-27)

## Description

### [Technical Field]

The present invention relates to a protective sheet for a solar battery module, a solar battery module equipped with the same, and a method for producing a solar battery module.

A solar battery module, which is a device capable of converting solar light energy into electric energy, has attracted special interest as a system capable of generating electricity without emitting carbon dioxide. It is necessary that the solar battery module have high generating efficiency and have durability that enables long-term use even when used outdoors.

The solar battery module is mainly constituted of solar battery cells as photovoltaic elements, an encapsulant including solar battery cells therein in a sealed state, and a protective sheet. A front protective sheet and a back protective sheet are adhered on the light receiving surface side (front side) of the solar battery module and the back side thereof, thereby preventing steam from penetrating into the solar battery module. It is required for such a protective sheet for a solar battery module to have excellent steam barrier properties and weatherability, and to have excellent adhesion with an encapsulant of the solar battery module.

Heretofore, there have been proposed, as methods for improving steam barrier properties, weatherability, adhesion to an encapsulant of a protective sheet for a solar battery module, for example, technologies disclosed in Patent Literatures 1 to 3.

Patent Literature 1 discloses a protective layer for a solar battery module having a laminate structure of an ultraviolet-shielding film made of a transparent weatherable resin, and a film made of an amorphous cyclic olefin copolymer having a glass transition temperature of 80°C or higher, laminated on the inside surface of the film. Patent Literature 2 discloses a surface protective sheet using a cyclic olefin copolymer, and a surface protective sheet in which a resin film such as a PET film is laminated on the inside surface of a cyclic olefin copolymer film through an adhesive layer.

Patent Literature 3 discloses a protective sheet for a solar battery module including a layer made of a cyclic olefin copolymer formed on both surfaces of a layer made of an ethylene-vinyl acetate copolymer.

### [Citation List]

### [Patent Literature]

[Patent Literature 1]
   Japanese Unexamined Patent Application, First Publication No. Hei 8-306948
[Patent Literature 2]
   Japanese Unexamined Patent Application, First Publication No. 2006-165434
[Patent Literature 3]
   Japanese Unexamined Patent Application, First Publication No. 2006-198922

### [Summary of Invention]

### [Technical Problem]

Conventional protective sheets disclosed in Patent Literatures 1 to 3 have a problem in that, in the step of tightly adhering a protective sheet to an encapsulant by lamination, ambient air remains as bubbles between the encapsulant and the protective sheet as a result of air entrainment. When the air remains, the encapsulant gradually peels away from the protective sheet and thus the function of the entire solar battery module may sometimes deteriorate.

Under the above circumstances, the present invention has been made, and an object of the present invention is to provide a protective sheet for a solar battery module which can prevent bubbles remaining and enable use over a long period of time.

### [Solution to Problem]

In order to achieve the above object, the present invention provides a protective sheet as defined in appended claim 1.

In the protective sheet for a solar battery module of the present invention, it is preferred that the heat-fusible sheet contains an ethylene vinyl acetate copolymer (EVA) and the content of vinyl acetate (VA) in the heat-fusible sheet is 20% by mass or less.

In the protective sheet for a solar battery module of the present invention, a fluorine-containing resin layer may be further laminated on a surface opposite to the surface, on which the heat-fusible sheet is laminated, of the base material sheet.

In the protective sheet for a solar battery module of the present invention, the base material sheet may be a resin sheet.

The present invention also provides a solar battery module in which the protective sheet for a solar battery module according to the present invention is adhered on either or both of the front side and the back side.

The present invention further provides a method for producing a solar battery module, which includes the step of laminating the protective sheet for a solar battery module according to the present invention on a surface of an encapsulant including a solar battery cell therein, using a vacuum thermocompression bonding method.

### [Advantageous Effects of Invention]

In the present invention, since the protective sheet for a solar battery module includes a base material sheet and a heat-fusible sheet made of a heat-fusible resin having a melting point measured by differential scanning calorimetry (a DSC method) of 80°C or higher and lower than 130°C, laminated on one surface of the base material sheet, and includes an air-flow path on a surface of the heat-fusible sheet, it is possible to provide a protective sheet for a solar battery module which can prevent bubbles remaining between the encapsulant and the protective sheet and enable use over a long period of time; and a solar battery module.

### [Brief Description of Drawings]

Fig. 1 is a schematic sectional view showing the first embodiment of a protective sheet for a solar battery module of the present invention.
Fig. 2 is a plan view showing an air-flow path having a lattice shape of a heat-fusible sheet of the present invention.
Fig. 3 is a plan view showing an air-flow path having an inclined lattice shape of a heat-fusible sheet of the present invention.
Fig. 4 is a sectional view showing an air-flow path of a heat-fusible sheet of the present invention.
Fig. 5 is a schematic sectional view showing a protective sheet for a solar battery module of the second embodiment of the present invention.
Fig. 6 is schematic sectional view showing an example of a solar battery module.

### [Description of Embodiments]

### [Protective Sheet for Solar Battery Module]

Embodiments of a protective sheet for a solar battery module of the present invention will be described below.

This mode is specifically described for more satisfactory understanding of the sprit of the invention and is in no way to be construed as limiting of the present invention unless otherwise specified.

### (1) First Embodiment

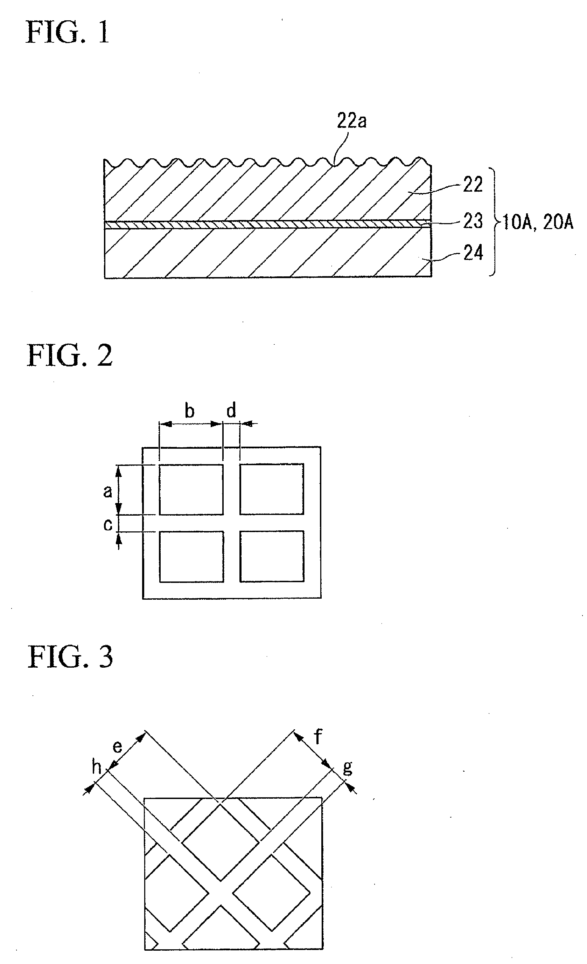

Protective sheets for a solar battery module 10A, 20A of the first embodiment shown in Fig. 1 include a base material sheet 24, and a heat-fusible sheet 22 laminated on one surface of the base material sheet 24.

In the protective sheets for a solar battery module 10A, 20A of the present invention, the heat-fusible sheet 22 is made of a heat-fusible resin whose melting point measured by a DSC method is 80°C or higher and lower than 130°C, and the heat-fusible sheet 22 includes an air-flow path 22a on the surface. When the heat-fusible sheet 22, the melting point of which, measured by a DSC method, is 80°C or higher and lower than 130°C is melted during thermocompression bonding, the air-flow path 22a formed on the surface of the heat-fusible sheet 22 after thermocompression bonding disappears and bubbles satisfactorily decrease, and thus adhesion can be improved.

The heat-fusible resin is preferably a resin containing an ethylene vinyl acetate copolymer (EVA), polyethylene, an ethylene-methacrylic acid copolymer (EMMA), an ethylene-acrylic acid copolymer (EMAA), an ethylene-glycidyl methacrylate copolymer (EGMA) and the like, and more preferably a resin containing EVA. Commonly, an encapsulant 30 constituting the solar battery module is often a resin composed of EVA. In that case, when the heat-fusible sheet 22 is made of a resin containing EVA, it is possible to improve compatibility and adhesion between the encapsulant 30 and the heat-fusible sheet 22.

When the heat-fusible sheet 22 contains EVA, the content of vinyl acetate (VA) in the heat-fusible sheet 22 is preferably 20% by mass or less, and more preferably 10% by mass or less.

As the encapsulant 30 constituting the solar battery module, an encapsulating resin composed of EVA is mainly used. The content of VA in the encapsulant is commonly from 25 to 40% by mass, and a melting point measured by a DSC method is often from 40 to 75°C. In an EVA-containing resin, as the content of VA in the resin increases, heat resistance deteriorates.

Accordingly, by decreasing the content of VA in the heat-fusible sheet 22 in the present invention when compared with the content of VA in a common encapsulant 30, a melting point of the heat-fusible sheet 22 is set at a temperature higher than a melting point of the common encapsulant 30. Therefore, in case the temperature is gradually raised using a laminate and a protective sheet for a solar battery module is laminated on the encapsulant 30, the encapsulant 30 is melted first and, after further raising the temperature, the heat-fusible sheet 22 is melted and thus the encapsulant 30 is adhered on the heat-fusible sheet 22. In the present invention, it is possible to efficiently decrease bubbles by providing the heat-fusible sheet 22, which has a higher melting point and exhibits late timing of melting when compared with the encapsulant 30, with the air-flow path 22a. The heat-fusible resin preferably has a melting point measured by a DSC method of lower than 130°C, and more preferably lower than 120°C, from the view point of heat fusibility. From the viewpoint of efficiency of a decrease in bubbles, the melting point measured by a DSC method is preferably 80°C or higher, and more preferably 90°C or higher.

The thickness of the heat-fusible sheet 22 may be appropriately adjusted according to the kind of the heat-fusible resin constituting the heat-fusible sheet 22. Usually, the thickness of the sheet 22 is preferably within a range from 1 to 200 µm. More specifically, when the heat-fusible sheet 22 is a sheet containing EVA, the thickness of the EVA sheet is preferably within a range from 10 to 200 µm, more preferably from 50 to 150 µm, and still more preferably from 80 to 120 µm from the viewpoint of lightweight properties and electrical insulation properties.

The air-flow path 22a is constituted by forming grooves on a surface (a surface opposite to the surface, on which a base material sheet is laminated) of the heat-fusible sheet 22.

There is no particular limitation on the method of forming an air-flow path 22a and it is possible to use a method of directly forming by embossing using an embossing roll, a method of forming a film on a casting sheet having an uneven shape imparted on a surface using a casting method and the like.

There is no particular limitation on the shape of the groove (recessed portion) of the air-flow path 22a, as long as it is a shape which is preferred to decrease bubbles, and the shape may be a lattice shape, a inclined lattice shape, a honeycomb shape, a shape of a plurality of linear or curved bands or lattices arranged in parallel, or a protean shape, when viewed as a planar view. Fig. 2 is a plan view showing a heat-fusible sheet 22 of the present invention in which an air-flow path having a lattice shape is formed as an embossed pattern, and Fig. 3 is a plan view showing a heat-fusible sheet 22 of the present invention in which an air-flow path having an inclined lattice shape is formed as an embossed pattern.

The size of the groove of the air-flow path 22a may be appropriately adjusted according to the shape of the groove to be formed or the like. When a lattice-shaped groove is formed as shown in Fig. 2, Fig. 3, and Fig. 4, each width indicated by the signs "c, d, g, h and k" of the lattice-shaped groove is preferably within a range from 10 to 1,000 µm, and more preferably from 50 to 600 µm.

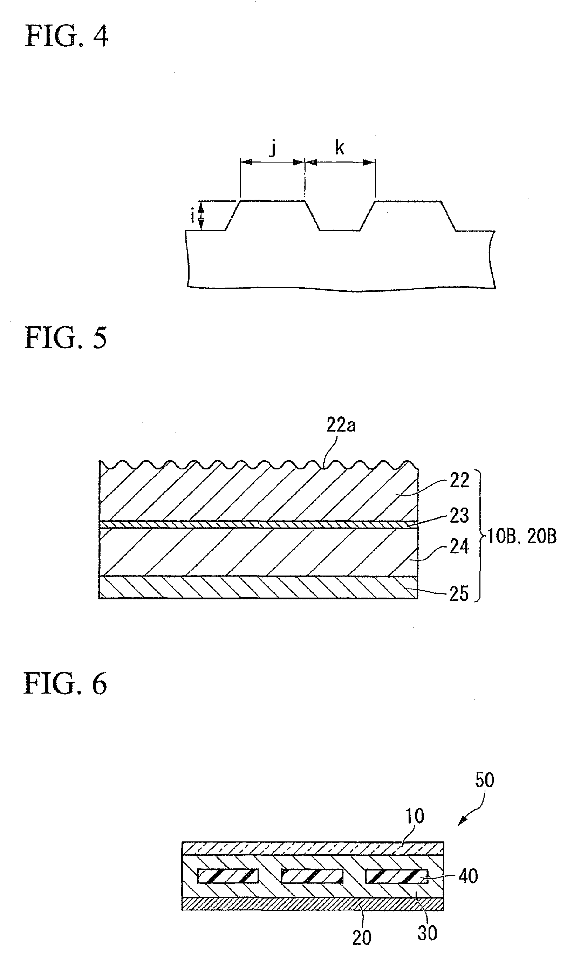

There is no particular limitation on the cross-sectional shape of the groove of the air-flow path 22a, as long as it is a shape which is preferred to decrease bubbles and includes, in addition to an inverted trapezoid shape shown in Fig. 4, a square shape, a triangle shape, a V-shape, a U-shape and the like.

The depth of the groove of the air-flow path 22a may be appropriately adjusted according to the thickness or the like of the heat-fusible sheet 22 on which the groove is formed and the depth indicated by the sign "i" is preferably within a range from 1 to 100 µm, and more preferably from 10 to 60 µm. The gap (protruding portion) between the groove and the groove of the air-flow path 22a may be appropriately adjusted according to the shape, size and the like of the groove to be formed. When the lattice-shaped groove is formed as shown in Fig. 2, Fig. 3 and Fig. 4, the gap between the groove and the groove indicated by the signs "a, b, e, f and j" is preferably within a range from 10 to 10,000 µm, and more preferably from 2,000 to 6,000 µm.

The base material sheet 24 in the protective sheet for a solar battery module 10A, 20A of the present invention may be a resin sheet or not, and is preferably a resin sheet from the viewpoint of flexibility, lightweight properties and the like.

When materials having no light transmittability are used as the base material sheet 24, the protective sheets for a solar battery module 10A, 20A are not used as a front protective sheet 10A which protects a front side of a solar battery module, but as a back protective sheet 20A which protects a back side of a solar battery module.

As the resin sheet, materials used commonly as a resin sheet in the protective sheet for a solar battery module are selected. Examples of the resin sheet include sheets made of polymers such as polyethylene, polypropylene, polystyrene, polymethyl methacrylate, polytetrafluoroethylene, polyamide (nylon 6, nylon 66), polyacrylonitrile, polyvinyl chloride, polyethylene terephthalate (PET), polybutylene terephthalate (PBT), polyethylene naphthalate (PEN), polyoxymethylene, polycarbonate, polyphenylene oxide, polyesterurethane, poly m-phenyleneisophthalamide, poly p-phenyleneterephthalamide and the like. Among these sheets, sheets made of polyesters such as PET, PBT and PEN are preferred, and a PET sheet is more preferred because of satisfactory electrical insulation properties, heat resistance, chemical resistance, dimensional stability and moldability.

The thickness of the resin sheet may be appropriately adjusted based on electrical insulation properties which are required to the solar battery module. Usually, the thickness is preferably within a range from 10 µm to 300 µm. More specifically, when the resin sheet is a PET sheet, the thickness is preferably within a range from 10 µm to 300 µm, and more preferably from 30 µm to 200 µm, from the viewpoint of lightweight properties and electrical insulation properties.

As long as the effects of the present invention are not adversely affected, the resin sheet may be subjected to a surface modification treatment so as to enhance weatherability, moisture resistance and the like. For example, it is possible to enhance weatherability, moisture resistance and the like of the protective sheet for a solar battery module by vapor deposition of silica (SiO₂) and/or alumina (Al₂O₃) on the PET sheet. Both surfaces of the resin sheet, or only any one of surfaces may be subjected to the vapor deposition treatment of silica and/or alumina.

There is no particular limitation on the method of laminating the base material sheet 24 on a the surface opposite to the surface (back surface), on which the air-flow path 22a is formed, of the heat-fusible sheet 22, as long as it does not adversely affect the effects of the present invention. It is possible to further provide an adhesive layer 23 between a base material sheet 24 and a heat-fusible sheet 22, and to laminate the base material sheet 24 and the heat-fusible sheet 22 through the adhesive layer 23.

It is preferred that the adhesive layer 23 contains an adhesive which has adhesion to the base material sheet 24 and the heat-fusible sheet 22.

There is no particular limitation on the adhesive, and examples thereof include an acrylic adhesive, an urethane-based adhesive, an epoxy-based adhesive, a polyester-based adhesive and the like. In order to improve adhesion, the heat-fusible sheet 22, and the surface of the adhesive layer side of the base material sheet 24 may be subjected to a corona treatment and/or a chemical treatment.

### (2) Second Embodiment

The protective sheets for a solar battery module 10B, 20B of the second embodiment shown in Fig. 5 include a base material sheet 24, and a heat-fusible sheet 22 laminated on one surface of the base material sheet 24, and a fluorine-containing resin layer 25 is laminated on a surface opposite to the surface, on which the heat-fusible sheet 22 is laminated, of the base material sheet 24. Weatherability and chemical resistance can be improved by providing the fluorine-containing resin layer 25. Accordingly, in order to improve weatherability and chemical resistance of the protective sheet for a solar battery module, the fluorine-containing resin layer 25 is preferably provided on one surface of the base material sheet 24 in the protective sheet for a solar battery module.

In Fig. 5, the same signs are used for constituent elements identical to materials of the protective sheets for a solar battery module 10A, 20A shown in Fig. 1, and repetitive descriptions are omitted.

In protective sheets for a solar battery module 10B, 20B of the present invention, a fluorine-containing resin layer 25 can be formed by applying a coating material containing a fluorine-containing resin on a surface opposite to the surface, on which a heat-fusible sheet 22 is laminated, of a base material sheet 24 so as to form a coating film having a desired thickness, followed by curing with drying.

There is no particular limitation on the coating material containing a fluorine-containing resin, as long as it does not adversely affect the effects of the present invention and forms the fluorine-containing resin layer 25 after curing with drying. The coating material may be a coating material, which is prepared by dissolving in a solvent or dispersed in water and can be applied on one surface of the base material sheet 24.

There is no particular limitation on the fluorine-containing resin contained in the coating material, as long as it does not adversely affect the effects of the present invention and is a resin containing fluorine. The fluorine-containing resin is preferably a resin which is dissolved in a solvent (an organic solvent or water) of the above coating material and is crosslinkable.

Preferred examples of the fluorine-containing resin include polymers containing chlorotrifluoroethylene (CTFE) as a main component, such as LUMIFLON (trade name) manufactured by ASAHI GLASS CO., LTD., CEFRAL COAT (trade name) manufactured by Central Glass Co., Ltd. and FLUONATE (trade name) manufactured by DIC Corporation; polymers containing tetrafluoroethylene (TFE) as a main component, such as ZEFFLE (trade name) manufactured by DAIKIN INDUSTRIES, Ltd.; polymers having a fluoroalkyl group, such as Zonyl (trade name) manufactured by E.I. duPont de Nemours and Company and Unidyne (trade name) manufactured by DAIKIN INDUSTRIES, Ltd.; and polymers including a fluoroalkyl unit as a main component. Among these, polymers containing CTFE as a main component and polymers containing TFE as a main component are preferred, and LUMIFLON (trade name) and ZEFFLE (trade name) are most preferred from the viewpoint of weatherability, pigment dispersibility or the like.

The coating material may contain, in addition to the fluorine-containing resin, a crosslinking agent (curing agent), a catalyst (crosslinking accelerator) and a solvent and, if necessary, it may contain inorganic and organic compounds such as a pigment, a dye and a filler.

There is no particular limitation on the composition of the coating material, as long as it does not adversely affect the effects of the present invention, and examples thereof include a coating material composition containing LUMIFLON (trade name) as a base, which is mixed with LUMIFLON (trade name), a pigment, a crosslinking agent, a solvent and a catalyst. With respect to a composition ratio, the content of LUMIFLON (trade name) is preferably from 3 to 80% by mass, and more preferably from 25 to 50% by mass; the content of the pigment is preferably from 5 to 60% by mass, and more preferably from 10 to 30% by mass; and the content of the organic solvent is preferably from 20 to 80% by mass, and more preferably from 30 to 70% by mass; based on 100% by mass of the entire coating material.

### [Solar Battery Module]

As shown in a schematic view of Fig. 6, a solar battery module 50 of the present invention can protect a solar battery cell 40 and an encapsulant 30 in the solar battery module 50 from wind and rain, moisture, dust and mechanical impact, and can block the inside of the solar battery module 50 from outside air, thus maintaining at a closed state, by laminating protective sheets for a solar battery module 10, 20 according to the present invention on a surface of an encapsulant 30 including a solar battery cell 40 therein.

The protective sheet for a solar battery module of the present invention can be preferably used not only as a front protective sheet 10, but also as a back protective sheet 20, and is more preferably used as a back protective sheet 20 from the viewpoint of light transmittability.

### [Method for Producing Solar Battery Module]

The method for producing a solar battery module of the present invention includes the step of laminating protective sheets for a solar battery module 10, 20 according to the present invention on a surface of an encapsulant 30 including solar battery cells therein, using a vacuum thermocompression bonding method.

When the protective sheets for a solar battery module 10, 20 of the present invention are laminated on the surface of the encapsulant 30, a surface of a heat-fusible sheet in the protective sheets for a solar battery module 10, 20 is laminated on the surface of the encapsulant 30.

It is preferred that the temperature in the case of employing the vacuum thermocompression bonding method is gradually raised within a range from 120°C to 150°C as a maximum temperature.

### [Examples]

The present invention will be described in more detail below by way of Examples, but the present invention is not limited to the following Examples.

### Example 1

Using a T-die extrusion film forming machine, EVA (EVAFLEX V5961, manufactured by DuPont-Mitsui Polychemicals Co., Ltd., ethylene/vinyl acetate = 91:9 (mass ratio), melting point measured by a DSC method: 97°C) was melt-extruded to form a film having a thickness of 100 µm. On the EVA film thus formed, an air-flow path with an uneven portion having a predetermined lattice shape shown in Fig. 2 was formed by embossing using a metal roll. Herein, the signs "a, b" were set at 3,000 µm, the signs "c, d" were set at 500 µm, a depth of a groove was set at 50 µm, and a cross-sectional shape of a groove was set at square. On a 125 µm thick hydrolysis resistant polyester film (Melinex 238, manufactured by Teijin DuPont Films Japan Limited), an urethane-based adhesive (prepared by mixing A-515 manufactured by Mitsui Chemicals, Inc. with A-3 manufactured by Mitsui Chemicals, Inc. in a ratio of 9:1) was applied by a mayer bar and dried at 80°C for 1 minute to form a 10 µm thick adhesive layer. The adhesive layer thus formed and the EVA film thus formed were laminated so that the adhesive surface of the layer thus formed faces the non-embossed surface of the EVA film to produce a protective sheet for a solar battery module.

### Example 2

In the same manner as in Example 1, except that an air-flow path with an uneven portion having a predetermined inclined lattice shape shown in Fig. 3 was formed on the EVA film by embossing using a metal roll, a protective sheet for a solar battery module was produced. Herein, the signs "e, f" were set at 5,000 µm, the signs "g, h" were set at 100 µm, a depth of a groove was set at 40 µm, and a cross-sectional shape of a groove was set at square.

### Example 3

As a coating material containing a fluorine-containing resin, a mixture of 100 parts by mass of LUMIFLON LF-200 (trade name, manufactured by ASAHI GLASS CO., LTD.), 10 parts by mass of SUMIDUR N3300 (trade name, manufactured by Sumika Bayer Urethane Co., Ltd.) and 30 parts by mass of Ti-Pure R105 (trade name, manufactured by E.I. duPont de Nemours and Company) was prepared. On one surface of an annealed polyester film (Melinex SA, manufactured by Teijin DuPont Films Japan Limited, 125 µm in thickness), this coating material containing a fluorine-containing resin was applied using a bar coater and then cured by drying at 130°C for 1 minute to obtain 15 µm thick fluorine-containing resin layer.

Then, on a surface opposite to the surface, on which the fluorine-containing resin layer of the annealed polyester film was formed, an adhesive layer was formed in the same manner as in Example 1. In the same manner as in Example 1, the adhesive layer thus formed and the EVA film with an air-flow path formed thereon were laminated so that the adhesive surface of the layer thus formed faces the non-embossed surface of the EVA film to produce a protective sheet for a solar battery module.

### Comparative Example 1

In the same manner as in Example 1, except that an EVA film with no air-flow path formed thereon was used, a protective sheet for a solar battery module was produced.

### <Evaluation of Remaining of Bubbles>

A protective sheet for a solar battery module (measuring 100 mm x 100 mm) and an EVA for an encapsulant (Ultra Pearl, manufactured by SANVIC INC., melting point measured by a DSC method: 72°C, measuring 400 µm x 100 mm x 100 mm) were laminated, and glass plate (measuring 1 mm x 125 mm x 125 mm) subjected to a release treatment was laminated on the side of EVA for an encapsulant. This protective sheet for a solar battery module/EVA for an encapsulant/glass plate laminate was placed in an oven at 23°C and 100 g of a balance weight was further placed on the glass plate and, after raising the temperature to 140°C, a heat treatment was carried out as it is for 20 minutes. After the heat treatment, the protective sheet was left to stand under the conditions of 23°C and 50% RH for 24 hours and then cooled to normal temperature. The glass plate was removed from the protective sheet for a solar battery module/EVA for an encapsulant/glass plate laminate to obtain a protective sheet for a solar battery module/EVA for an encapsulant. The side surface of EVA for an encapsulant of the obtained protective sheet for a solar battery module/EVA for an encapsulant was imaged at 50 times magnification using a microscope (KH-7700, manufactured by HIROX Co., Ltd.). Imaged file was analyzed by binarization using an image analyzing software Image Pro-plus (trade name, manufactured by Media Cybernetics) and an area of bubbles entered into a space between the protective sheet for a solar battery module and EVA for an encapsulant was calculated. The results are shown in Table 1.

**Table 1**

| | Bubble area (%) |
|---|---|
| Example 1 | 0.1 |
| Example 2 | 0.2 |
| Example 3 | 0.1 |
| Comparative Example 1 | 2.7 |

The above results revealed that the groove of protective sheets for a solar battery module of Examples 1 to 3 according to the present invention disappeared and prevented bubbles from remaining.

### [Industrial Applicability]

According to the present invention, since the protective sheet for a solar battery module includes a base material sheet and a heat-fusible sheet made of a heat-fusible resin having a melting point measured by differential scanning calorimetry (a DSC method) of 80°C or higher and lower than 130°C, laminated on one surface of the base material sheet, and includes an air-flow path on a surface of the heat-fusible sheet, it is possible to provide a protective sheet for a solar battery module which can prevent bubbles remaining between the encapsulant and the protective sheet and enable use over a long period of time; and a solar battery module.

### [Reference Signs List]

10A, 10B, 10: Protective sheet for solar battery module (Front protective sheet)
20A, 20B, 20: Protective sheet for solar battery module (Back protective sheet)
22: Heat-fusible sheet
22a: Air-flow path
23: Adhesive layer
24: Base material sheet
25: Fluorine-containing resin layer
50: Solar battery module
30: Encapsulant
40: Solar battery cell
a, b, e, f, j: Gap between groove and groove of air-flow path
c, d, g, h, k: Width of groove of air-flow path
i: Depth of groove of air-flow path

## Claims

1. A protective sheet (10, 20) for a solar battery module comprising a base material sheet (24) and a heat-fusible sheet (22) made of a heat-fusible resin having a melting point measured by differential scanning calorimetry (a DSC method) of 80°C or higher and lower than 130°C, laminated on one surface of the base material sheet (24), and comprising an air-flow path (22a) on a surface of the heat-fusible sheet (22) which is opposite to the surface on which the base material sheet (24) is laminated.

2. The protective sheet (10, 20) for a solar battery module according to claim 1, wherein the heat-fusible sheet (22) contains an ethylene vinyl acetate copolymer (EVA) and the content of vinyl acetate (VA) in the heat-fusible sheet is 20% by mass or less.

3. The protective sheet (10, 20) for a solar battery module according to claim 1, wherein a fluorine-containing resin layer (25) is laminated on a surface opposite to the surface on which the heat-fusible sheet (22) is laminated of the base material sheet (24).

4. The protective sheet (10, 20) for a solar battery module according to claim 1, wherein the base material sheet (24) is a resin sheet.

5. A solar battery module (50) comprising the protective sheet (10, 20) for a solar battery module according to claim 1.

6. A method for producing a solar battery module (50), which comprises the step of laminating the protective sheet (10, 20) for a solar battery module according to claim 1 on a surface of an encapsulant (30) including a solar battery cell (40) therein, using a thermocompression bonding method.

## Patentansprüche

1. Schutzschicht (10, 20) für ein Solarbatteriemodul, umfassend eine Basismaterialschicht (24) und eine wärmeschmelzbare Schicht (22), die aus einem wärmeschmelzbaren Kunstharz hergestellt ist, der einen durch dynamische Differenz-Thermoanalyse (ein DSC Verfahren) gemessenen Schmelzpunkt von 80°C oder höher und geringer als 130°C hat, die auf eine Oberfläche der Basismaterialschicht (24) laminiert ist und einen Luftströmungspfad (22a) auf einer Oberfläche der wärmeschmelzbaren Schicht (22) umfasst, die der Oberfläche entgegengesetzt ist, auf die die Basismaterialschicht (24) laminiert ist.

2. Schutzschicht (10, 20) für ein Solarbatteriemodul gemäß Anspruch 1, wobei die wärmeschmelzbare Schicht (22) ein Ethylenvinylacetat-Copolymer (EVA) enthält, und der Gehalt von Vinylacetat (VA) in der wärmeschmelzbaren Schicht 20 Gewichtsprozent oder weniger ist.

3. Schutzschicht (10, 20) für ein Solarbatteriemodul gemäß Anspruch 1, wobei eine Fluor enthaltende Harzschicht (25) auf eine Oberfläche der Basismaterialschicht (24) laminiert ist, die der Oberfläche entgegengesetzt ist, auf die die wärmeschmelzbare Schicht (22) laminiert ist.

4. Schutzschicht (10, 20) für ein Solarbatteriemodul gemäß Anspruch 1, wobei die Basismaterialschicht (24) eine Harzschicht ist.

5. Solarbatteriemodul (50), umfassend die Schutzschicht (10, 20) für ein Solarbatteriemodul gemäß Anspruch 1.

6. Verfahren zum Herstellen eines Solarbatteriemoduls (50), das den Schritt des Laminierens der Schutzschicht (10, 20) für ein Solarbatteriemodul gemäß Anspruch 1 auf eine Oberfläche einer Einkapselung (30) umfasst, in der eine Solarbatteriezelle (40) enthalten ist, unter der Verwendung eines Thermokompressionsschweißverfahrens.

## Revendications

1. Feuille protectrice (10, 20) pour un module de batterie solaire comprenant une feuille de matériau de base (24) et une feuille thermofusible (22) réalisée à partir d'une résine thermofusible ayant un point de fusion mesuré par analyse calorimétrique à compensation de puissance (méthode DSC) de 80 °C ou supérieur et inférieur à 130 °C, déposée en couche sur une surface de la feuille de matériau de base (24), et comprenant une trajectoire d'écoulement d'air (22a) sur une surface de la feuille thermofusible (22) qui est opposée à la surface sur laquelle la feuille de matériau de base (24) est déposée.

2. Feuille protectrice (10, 20) pour un module de batterie solaire selon la revendication 1, dans laquelle la feuille thermofusible (22) contient un éthylène-acétate de vinyle (EVA) et le contenu d'acétate de vinyle (VA) dans la feuille thermofusible est de 20 % en poids ou moins.

3. Feuille protectrice (10, 20) pour un module de batterie solaire selon la revendication 1, dans laquelle une couche de résine contenant du fluor (25) est déposée en couche sur une surface opposée à la surface sur laquelle la feuille thermofusible (22) est déposée en couche sur la feuille de matériau de base (24).

4. Feuille protectrice (10, 20) pour un module de batterie solaire selon la revendication 1, dans laquelle la feuille de matériau de base (24) est une feuille en résine.

5. Module de batterie solaire (50) comprenant la feuille protectrice (10, 20) pour un module de batterie solaire selon la revendication 1.

6. Procédé pour produire un module de batterie solaire (50) comprenant l'étape consistant à déposer en couche la feuille protectrice (10, 20) pour un module de batterie solaire selon la revendication 1, sur une surface d'un agent d'encapsulation (30) comprenant une cellule de batterie solaire (40) à l'intérieur de ce dernier, en utilisant un procédé de liaison par thermocompression.
